# EUROPEAN PATENT APPLICATION

(11) **EP 4 672 300 A2**
(43) Date of publication of application: **31.12.2025**
(21) Application number: 25175394.3
(22) Date of filing: 09.05.2025
(51) Int. Cl.: H01J 37/302

(54) **APPARATUS AND METHOD FOR WRITING A MOVEABLE TARGET IN A MULTI-COLUMN EXPOSURE APPARATUS**

(30) Priority: 10.05.2024 EP 24175159
(71) Applicant: IMS Nanofabrication GmbH, 2345 Brunn am Gebirge (AT)
(72) Inventor: Platzgummer, Elmar, 1090 Vienna (AT); Haberler, Michael, 1090 Vienna (AT)
(74) Representative: Patentanwaltskanzlei Matschnig & Forsthuber OG

(57) **Abstract**

A charged-particle writing method for writing a desired pattern on a target using a charged-particle multi-beam processing apparatus includes writing multiple exposure stripes (51) along a main direction. The apparatus includes a plurality of particle-optical columns (411, 413) arranged in an array over the target plane, with said columns forming least two lines extending perpendicular to the main direction. By virtue of a relative movement between said target and the particle-optical columns along the main direction while the particle-optical columns generate pattern portion images on the target, the columns write the exposure stripes (51) on the target, each exposure stripe being exposed by either one single particle-optical column or one group of two or more particle-optical columns arranged along said main direction. In the direction perpendicular to the main direction, the row offset is at least twice the width of the stripes. Between writing the exposure stripes the particle-optical columns are moved relative to the target so that the target bypasses the base points of the particle-optical columns.

## Description

### Field of the Invention

The present invention relates to certain improvements in writing a pattern using a charged-particle multi-beam processing apparatus, in particular with regard to improved positioning of charged-particle beams, where the multi-column charged-particle exposure apparatus is equipped with a moveable stage for generating a relative movement between a target to be exposed and an array of charged-particle columns employing charged particles for writing a pattern or respective pattern positions on the target.

The applicant has realized charged-particle multi-beam apparatuses and developed the corresponding charged-particle optical components, pattern definition devices, and writing methods for multiple beams, and commercialized a 50 keV electron multi-beam writer called eMET (electron Mask Exposure Tool) or MBMW (multi-beam mask writer), used to realize arbitrary photomasks for 193nm immersion lithography, as well as masks for EUV lithography and templates for nanoimprint lithography. Systems devised by the applicant have also been called PML2 (Projection Mask-Less Lithography) for electron beam direct writer (EBDW) applications for performing writing processes on substrates. Further details can be found, for instance, in the patents US 9,053,906, US 9,520,268, US 6,768,125, US 8,222,621 and US 8,378,320 by the applicant.

Additionally, the applicant has developed multi-column-exposure apparatuses for direct-write applications on 12" wafers or 6" photomasks in US 7,214,951 and US 9,443,699 B2. A typical multi-column system includes multiple charged-particle-optical columns, each of which comprises an illuminating system that delivers a broad telecentric charged-particle beam to a pattern definition system followed by a charged-particle projection optics, which includes, e.g., a number of electrostatic and/or electromagnetic lenses. Furthermore, in US 2023/0015805 A1, the applicant presented a ("slim") lens optimized for multi-column applications which enables multi-column systems with increased electrical current and throughput.

The above -mentioned patent documents are herewith included by reference into the present disclosure.

The inventors observed that conventional writing processes using charged particles are often problematic in that during the exposure process charged particles leak to the target. Possible origins for such charged-particle leakage are the non-instantaneous blanking mechanism, defective blanking of beamlets, or interference or scattering effects of the charged particles within the optical system. Even when all beams are blanked out by the patterning definition system, a certain amount of dose will be deposited towards the target. In particular, when using resists that allow for a higher resolution, but also require a higher dose, there will often be a need to increase the beam current to ensure manageable writing times, i.e. throughput. The increased beam current exacerbates the problem. This leaked additional dose results in patterning errors and in particular undesirable modifications of the critical dimension of pattern components.

Therefore, it is an object of the invention to provide approaches that help to reduce the impact of the charged-particle leakage upon patterning accuracy and critical dimension.

### Summary of the Invention

This object is met by a charged-particle multi-beam processing apparatus and a method for writing a desired pattern on a target using such apparatus as set out in the claims. In particular, a first aspect of the invention provides a charged-particle multi-beam processing apparatus for exposure of a target to write a desired pattern thereon using a plurality of beams of electrically charged particles. The target has a total area, and within the area of the target there is defined an exposure region where the desired pattern is to be written, and this apparatus comprises a target stage for receiving the target and a plurality of particle-optical columns configured for directing respective charged-particle beams towards the target and thereby writing the desired pattern on the target, with the target stage being configured to position the target, relative to the plurality of particle-optical columns, at a specific position within a predefined target plane and a main direction defined therein; the particle-optical columns are arranged (typically, mutually parallel) along respective longitudinal axes traversing the target plane at respective base points (which preferably are mutually different), and the particle-optical columns are, as regards their respective base points, arranged according to a pre-defined array (such as a regular array or a staggered array), within which the particle-optical columns form at least two (m ≥ 2) lines extending perpendicular to said main direction and comprising each at least one (and preferably two or more) particle-optical column, where in the case of any line comprising more than one particle-optical column (n ≥ 2) within such line the particle-optical columns are spaced apart, or more exactly offset to each other, by a row offset (as measured perpendicular to the main direction), and these lines are offset relative to each other according to a longitudinal spacing (as measured along the main direction), wherein each particle-optical column is configured to project its respective charged-particle beam onto the target at a respective region around the respective base point to generate, in said region, a pattern portion image corresponding to a portion of a pattern to be exposed on the target in accordance with the location of the respective base point of the particle-optical column within the target plane, said pattern portion image having a lateral width as measured across said main direction, referred to as "stripe width", where the row offset is at least twice the stripe width (where n ≥ 2; in the case of lines where n=1, the row offset is irrelevant); wherein the charged-particle multi-beam processing apparatus is configured to generate a relative movement between said target and the plurality of particle-optical columns along said main direction while said plurality of particle-optical columns (simultaneously) generate a plurality of pattern portion images on the target, thus moving the pattern portion images across the target along respective paths along said main direction and writing exposure stripes on the target running substantially parallel to each other along said main direction.

This solution offers an efficient way to reduce the undesired effects of charged-particle leakage while maintaining the highly demanding requirements for patterning fidelity and throughput. The invention involves moving the entire substrate (herein, the terms "substrate" and "target" are used interchangeably) is moved constantly relative to the columns, i.e. the stripes span the entire width of the substrate. In consequence, the leaked dose due to charged-particle leakage will be distributed and applied homogeneously along the stripe, furthermore, using multiple stripes stitched along the write direction may additionally help to obtain a homogeneous distribution of leaked dose also orthogonal to the stripes. It is then straightforward to re-calibrate the nominal dose for the exposure to account for the effect of leaked dose; in fact, test exposures to determine the required nominal dose are already part of usual calibrating procedure and thus will "automatically" take account of this effect. Thus, by using the described write strategy with stripe stitching along the write direction it is possible to ensure a correct exposure dose across the entire pattern and thereby a high pattern fidelity of the writing process.

Many embodiments may provide for exposure of stripes at mutual offsets. For this, the mentioned steps of the method may be repeated, each time at a lateral offset as measured perpendicular to the main direction, with respect to the respectively preceding completion of said steps, said lateral offset being not larger than the stripe width, for exposing an exposure region on the target, which is defined as the region where the desired pattern is to be written. Alternatively, the exposure stripes may be formed within a pre-defined exposure region on the target traversing the exposure region along the main direction, wherein the exposure stripes formed during each single traversal of the exposure region cover only a fraction of the exposure region, and the forming of exposure stripes is repeated with respective offsets perpendicular to the main direction so as to cover the exposure region.

Moreover, between each repeat (or repetition) it may be advantageous that when the stage repositions the target it employs a repositioning path of the target which, at least with respect to the exposure region, bypasses the base points of the particle-optical columns. This further improves reducing the undesired effects of charged-particle leakage. In suitable embodiments, the repositioning path comprises a path portion which bypasses the base points of the particle-optical columns by moving (as a relative movement between the target and the columns) the plurality of particle-optical columns to locations where all base points of the particle-optical columns are completely outside of the exposure region or the total area of the target.

Generally, the exposure region (also referred to as exposure area herein) is the portion of the target area comprising all areas on the target which is exposed for writing the desired pattern on the target. In particular, in the case where the target is a mask to be written, the exposure region will comprise all or at least a large part (e.g. at least about 90 %) of the target area. As alternative example, in case of a wafer target comprising a number of die fields, the exposure region is usually one of the die fields; however, in case where the writing procedure is conceived as affecting multiple die fields pattern, it will be suitable to have the combination of all die fields affected as the exposure region according to the invention. In the latter case the exposure region is the portion of the target area that comprises all areas where patterns are written.

In many embodiments of the apparatus according to the invention, each particle-optical column may advantageously comprise an illumination system, a beam shaping device, and a projection optics system; with the illumination system being configured to produce a respective beam and form it into a substantially telecentric beam illuminating the shaping means, the beam shaping device being configured to form the shape of the illuminating beam into a pattern portion composed of a multitude of sub-beams, said pattern portion corresponding to a portion of a pattern to be exposed on the target in accordance with the location of the respective base point of the particle-optical column within the target plane, and the projection optics system being configured to project an image of the beam shape defined in the shaping means onto the target thus forming said pattern portion image.

Furthermore, the apparatus may be configured to repeat the process of writing exposure stripes at least once, preferably multiple times, each time at a lateral offset with respect to the respectively preceding process of writing exposure stripes, where the lateral offset, as measured perpendicular to the main direction, is not larger than the stripe width.

Preferably, the particle-optical columns may be arranged in a rectangular array having n rows of particle-optical columns, each such row extending perpendicular to the direction of the lines and comprising m particle-optical columns, with n ≥ 1 and m ≥ 2. (Thus, m is the same as the number of lines.) In another preferable arrangement, the particle-optical columns may be arranged in a staggered array having n rows of particle-optical columns, with n ≥ 1, each such row comprising m ≥ 2 columns, wherein adjacent particle-optical columns within a row are offset by a transversal offset which is smaller than the longitudinal spacing (i.e., the spacing between adjacent lines) which preferably is half of the row offset or 1/m of the row offset. Often and more preferably, n ≥ 2 and/or m ≥ 2. It is remarked that in the special case that n = 1, a line reduces to containing just one particle-optical column, and the offset between neighboring such "lines" (of one single column each) according to the longitudinal spacing is the component of the distance between the columns along the main direction.

According to another aspect of the invention, a method for writing a desired pattern on a target using a charged-particle multi-beam processing apparatus is provided, with the apparatus including a target stage configured to receive and position the target within a predefined target plane, said target plane having a main direction defined therein, and a plurality of particle-optical columns configured for directing respective charged-particle beams towards the target and thereby writing the desired pattern on the target; the particle-optical columns are arranged (typically, mutually parallel) along respective longitudinal axes traversing the target plane at respective base points (which preferably are mutually different), and the particle-optical columns are, as regards their respective base points, arranged according to a pre-defined array (such as a regular array or a staggered array), within which the particle-optical columns form at least two lines extending perpendicular to said main direction, where these at least two lines each comprise at least one particle-optical column, and the lines are offset to each other according to a longitudinal spacing as measured along the main direction, and within each of said lines which comprises more than one particle-optical column (i.e., n > 1) the particle-optical columns are distanced according to a uniform row offset, and the method comprises the steps of:
positioning, using the target stage, the target at a specific position within the target plane and relative to the plurality of particle-optical columns,
projecting, in each particle-optical column, a respective charged-particle beam onto the target at a respective region around the respective base point to generate, in said region, a pattern portion image corresponding to a portion of a pattern to be exposed on the target in accordance with the location of the respective base point of the particle-optical column within the target plane, said pattern portion image having a lateral width as measured across said main direction, referred to as "stripe width", where the row offset (for lines where n > 1) is at least twice the stripe width;
generating a relative movement between said target and the plurality of particle-optical columns along said main direction while said plurality of particle-optical columns (simultaneously) generate a plurality of pattern portion images on the target, and thus moving the pattern portion images across the target along respective paths along said main direction and writing exposure stripes on the target running substantially parallel to each other along said main direction, each exposure stripe being exposed by either one single particle-optical column or one group of two or more particle-optical columns arranged along said main direction.

Also this method according to the invention offers the advantages as explained above with respect to the apparatus of the invention. Further advantageous developments of the method include the following:
Also, in many embodiments it may be preferable to have the stripes written in a complete number of repeats being written in a consecutive order in at least two passes, wherein each stripe belongs to exactly one of said passes, wherein for each pass, the widths of the stripes of one pass combine into a cover of the width of the exposure region as measured across said main direction, and wherein each pass is associated with one of a number of partial grids of pattern pixels which are exposable during the respective pass, the partial grids being mutually different and, when taken together, combining to the complete plurality of pattern pixels which compose the pattern to be exposed in the exposure region.

In this case, it may be of further advantage to have each particle-optical column contribute to writing portions of the desired pattern in each of the at least two passes, and preferably contribute to writing mutually corresponding portions between the passes. Another further development may provide that, where each pass is associated with one of a plurality of groups of particle-optical columns (the groups of particle-optical columns being mutually disjoint), the stripes of each pass are exposed only by particle-optical columns of the respectively associated group of particle-optical columns. Furthermore, the writing process may additionally be such that during writing of each single stripe, the particle-optical columns of a row (i.e., the particle-optical columns at corresponding positions within each line, as measured along the direction of extension of the lines) contribute to the same stripe exposing the same partial grid, and the writing of the stripe is repeated to expose each of the number of partial grids.

In another suitable development of the invention, during an exposure process for writing the desired pattern and with respect to grid rows of particle-optical columns formed by particle-optical columns located at corresponding positions within each line (in particular, as measured along the direction of extension of the lines), one suitable approach for dealing with defects may be that for each row a selected particle-optical column in each row is switched off during the exposure process, wherein the selected particle-optical columns of the rows are mutually corresponding with respect to the desired pattern being written by writing exposure stripes. For instance, upon detection of a particle-optical column being defective (or otherwise unsuitable for a writing process), this defective column is selected as a particle-optical column to be switched off, namely, for the row of particle-optical columns to which this defective column belongs, and in each of the other rows a particle-optical column of the respective row is chosen for being switched off, where the particle-optical column thus selected is corresponding to the defective column. Herein, "corresponding particle-optical columns" means that in the writing process, which involves writing exposure stripes, particle-optical columns are "corresponding" if they are writing portions of the desired pattern (possibly and suitably in different exposure stripes) at the same time or at the same X position relative to the start of the respective stripe or within the same partial grid, or any suitable combination thereof.

Furthermore, some embodiments may also employ overlapping margins at adjacent stripes. This may be achieved by realizing the stripes such that at least two stripes written by different columns are partly overlapping, wherein in the range of overlap of stripes with respect to pattern pixels forming the desired pattern, nominal positions of pattern pixels of one of the two stripes are overlapping with nominal positions of corresponding pattern pixels of the other of the two stripes, and pattern pixels are exposed in the at least two overlapping stripes in a complementary manner with regard to the desired pattern.

### Short Description of the Drawings

In the following, in order to further demonstrate the present invention, illustrative and non-restrictive embodiments are discussed, as shown in the drawings, which schematically show:
- Fig. 1: a multi-column writer tool suitable for implementing the invention in a longitudinal section;
- Fig. 2: depicts an example of a multi-column array according to a regular rectangular array;
- Fig. 3: depicts another example of a multi-column array according to a regular staggered array;
- Figs. 4A to 4E: illustrate respective stages of an exemplary exposure process for writing a pattern on a target;
- Fig. 5: shows a variant of the multi-column array of Fig. 3, which also includes deviations from nominal positions of the regular grid due to limited precision of positioning;
- Fig. 6: illustrates overlap margins implemented in a variant to the process of Figs. 4A-E; and
- Fig. 7: shows a detail of Fig. 6 to illustrate the determination of suitable parameters for the overlap margins.

### Detailed Description of Embodiments

The detailed discussion of exemplary embodiments of the invention given below discloses the basic ideas, implementation, and further advantageous developments of the invention. It will be evident to the person skilled in the art to freely combine several or all of the embodiments discussed here as deemed suitable for a specific application of the invention. Throughout this disclosure, terms like "advantageous", "exemplary", "typical", or "preferred" indicate elements or dimensions which are particularly suitable (but not essential) to the invention or an embodiment thereof, and may be modified wherever deemed suitable by the skilled person, except where expressly required. It will be appreciated that the invention is not restricted to the exemplary embodiments discussed in the following, which are given for illustrative purpose and merely present suitable implementations of the invention. Within this disclosure, terms relating to a vertical direction, such as "upper" or "down", are to be understood with regard to the direction of the particle-beam traversing the electromagnetic lens, which is thought to run downwards ("vertically") along a central axis (or longitudinal axis). This longitudinal axis is generally identified with the Z direction, to which the X and Y directions are transversal.

### Lithographic Apparatus

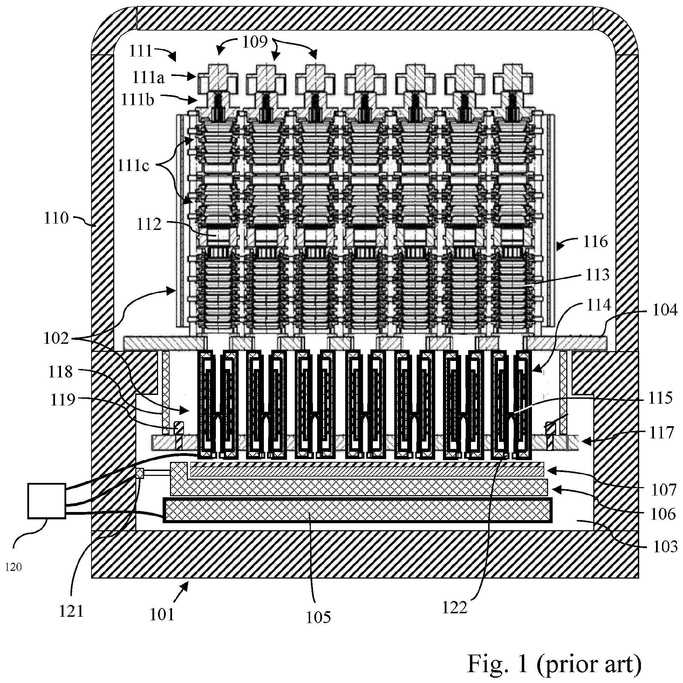

Generally, the invention is suitable for generic multi-column charged-particle exposure apparatuses such as arrays of Variable Shaped Beam or Gaussian Beam systems. In a favorable embodiment of the invention, it is utilized in conjunction with a multi-column multi-beam charge particle apparatus such as the multi-column writer tool shown in a schematic sectional view in Fig. 1. The writer tool employs a charged-particle beam formed from charged particles which may be electrons or ions (for instance ions of positive electric charge).

The writer tool 101 comprises a vacuum housing 110 for the multi-column charged-particle optics 102, a target chamber 103 onto which the multi-column charged-particle optics is mounted by means of a column base plate 104. Within the target chamber 103 is an X-Y stage 105, e.g. a air-bearing vacuum stage which is controlled by a distance-measurement system 121 and corresponding control unit 120 onto which a substrate chuck 106, preferably an electrostatic chuck, is mounted using a suitable handling system. The chuck 106 holds the substrate 107 serving as target, such as a silicon wafer or a photomask with an electron or ion beam sensitive resist layer.

The multi-column optics 102 comprises a plurality of particle-optical columns 109. Preferably, the columns 109 have identical setup and are installed side-by-side with mutually parallel axes. Each column has an illuminating system 111 including an electron or ion source 111a, an extraction system 111b, and an electrostatic multi-electrode condenser optics 111c, delivering a broad telecentric charged-particle beam to a pattern definition (PD) system 112 being adapted to let pass the beam only through a plurality of apertures defining the shape of sub-beams ("beamlets") permeating said apertures (beam shaping device), and a demagnifying charged-particle projection optics 116, composed of a number of consecutive electro-magnetooptical projector stages, which preferably include electrostatic and/or magnetic lenses, and possibly other particle-optical devices. In the embodiment shown in Fig. 1, the projection optics 116 comprises e.g. a first lens 113 which is an accelerating electrostatic multi-electrode lens, whereas a second lens 114, located downstream of the first lens, is realized using an electromagnetic lens.

In each column 109, the first lens 113 of the projection optics forms a first cross-over of the particle beam, whereas the second lens 114 forms a second cross-over. In the second lens a beam aperture 115 is configured to filter out beam parts which deviate from the respective optical axis since they have been deflected in the PD system. Each second lens 114 of the columns may be preferably mounted on a reference plate 117 which is mounted by suitable fastening means 118 onto the column base plate 104. Mounted onto the reference plate 117 are parts 119 of an off-axis optical alignment system. For positioning and shaping the beams as it traverses the columns, each column comprises a multipole electrode system to be used in conjunction with the projection optics. The write multipoles 122, in particular, serve to position the patterned beams of each column in relation to each other and to the stage 105.

The reference plate is fabricated from a suitable base material having low thermal expansion, such as a ceramic material based on silicon oxide or aluminum oxide, which has the advantage of little weight, high elasticity module and high thermal conductivity, and may suitably be covered with an electrically conductive coating, at least at its relevant parts, in order to avoid charging (by allowing electrostatic charges to be drained off).

The PD system 112 of each column serves to form the particle beam into a plurality of so-called beamlets which contain the information of the pattern to be transferred to the target. The structure, operation and data-handling of the PD system are disclosed in US 9,443,699 and US 9,495,499 of the applicant, the disclosure of which is herewith included by reference.

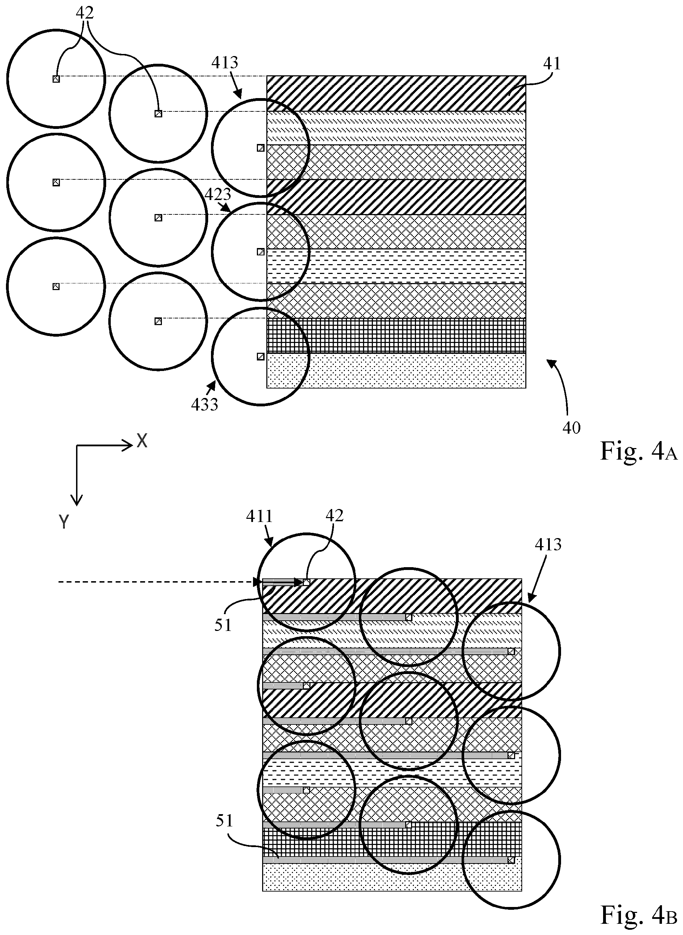

During a writing process on the target, specifically within the exposure region, which is the region of the target where the desired pattern is to be written, each of the particle-optical columns generates an image of the apertures in the PD system (pattern portion image) on the target; thus, a number of pattern portion images is generated, located at corresponding locations, or actually, areas of limited size, on the target surface. These locations/areas are referred to as "beam fields" (indicated as squares 42 in Figs. 4A-4E). The writing process employs a relative movement between the target and the array of particle-optical columns, in order to generate a scanning movement of the pattern portion images across the target surface. Thus, the beam fields are moved over the target surface, so as to write exposure stripes, or short "stripes". It is important to note that for a writing process and according to the invention, only the relative motion between target and columns is relevant; typically, the relative movement between the target and the array of particle-optical columns is realized by moving the target and keeping the columns fixed in place.

### Multi-Column Architecture

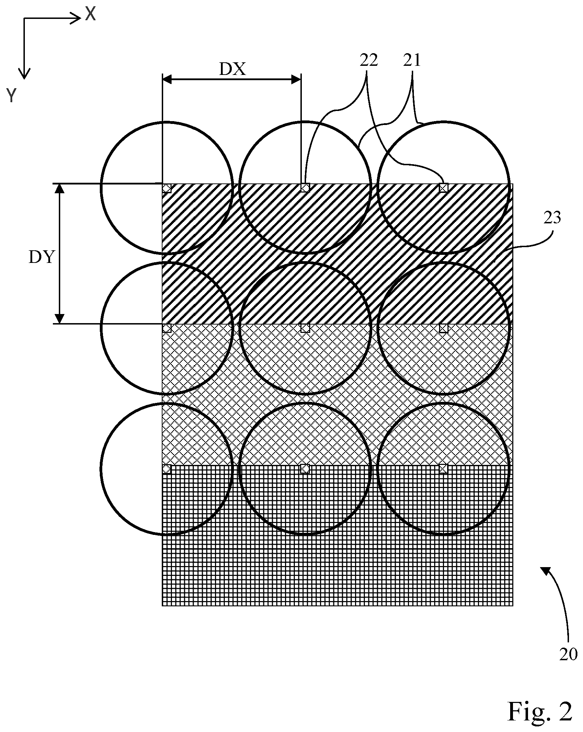

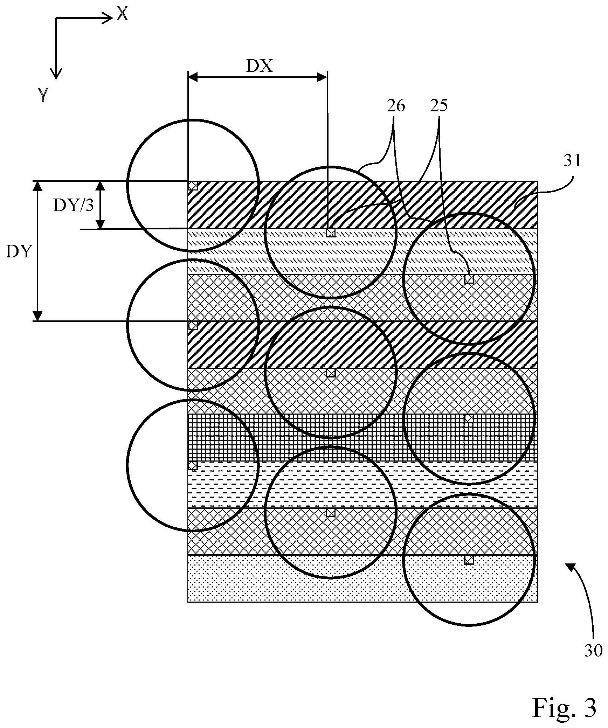

Figs. 2 and 3 illustrate examples of column arrangements that are suitable for the invention, designed for writing patterns in corresponding column exposure fields.

Referring to Fig. 2, a rectangular layout of charged-particle columns is illustrated in a top view. Therein, the circumference of each column is indicated by a respective black circle 21 and the area covered by its beam field is indicated by a respective small square 22 in the center of the respective circle 21 (the size of the squares is exaggerated for clarity, since in typical implementations the beam field 22 is considerably smaller than the lateral width of a column circumference 21). In the example shown, the particle-optical columns are arranged in a regular rectangular grid which includes n=3 grid rows each comprising m=3 particle-optical columns arranged along the main direction, which is tagged as X in Fig. 2, with respective pitches DX and DY (the pitches DY and DY may be the same, in which case the rectangular grid is a square grid); the center of each square 22 also represents the center of one respective particle-optical column positioned over the target plane at a preferably orthogonal angle thereto. The arrangement of Fig. 2 can also be seen as a number m=3 of grid lines extending along the Y direction of Fig. 2 and each having a number n=3 of particle-optical columns; the lines are spaced apart by a longitudinal spacing DX as measured along the X direction. The offset DY of the columns within each line is also referred to as row offset. Evidently the numbers n, m may be varied as needed in a specific implementation, for instance n,m = 2, 3, 4, ... or a power of 2 (2^{k}, k>1) or any multiple thereof. One particularly suitable implementation has e.g.: m=2, n=3. The exposure region or exposure area 20 on the target, which may be a wafer or a mask, is partitioned into a plurality of exposure fields 23 (illustrated by different ways of hatching) each of which is assigned to one or more rows of columns; each exposure field 23 is then designated to be exposed by the columns of the respective row. In Fig. 2, the columns of each row are assigned to the same exposure field; this is also indicated by the hatching, in that the beam fields of the rows have the same hatching.

In order to avoid confusion of terms, the "columns" of the grid-layout (which extend along the Y direction of Figs. 2-7) are referred to as "grid column lines" or simply "column lines"; in contrast thereto, a simple mention of a "column" refers to a particle-optical column, unless it is otherwise clear from the context.

Fig. 3 shows another embodiment of the invention. Here, the columns, represented again by their circumferences 26 with corresponding beam fields 25, are arranged in a staggered grid with n=3 × m=3 columns and pitches DX and DY, wherein a transversal offset DY/3 is present between subsequent column lines. This allows to restrict the column exposure fields along the Y direction only, and thus they form stripes 31, which the plurality of stripes 31 together covering the complete exposure area 30. In this case, each column of the layout is assigned to a separate exposure field as indicated by the different hatching for each of the exposure fields. It will be evident that the transversal offset may be chosen differently in other embodiments as will be suitable for a specific writing strategy.

The choice of suitable values for the longitudinal spacing DX and row offset DY will depend on the specific implementation, but is subject to mechanical constraints of the particle-optical columns, such as the lateral width of the footprint of the columns with respect to the target plane. In this context, implementing the applicant's "slim" column lens, described in US 2023/0015805 A1 mentioned above, allows to reduce the spacing between columns to a typical value of 2 inches. An arrangement of e.g. six columns according to n=3, m=2 or n=3, m=3 with such a spacing is favorable considering a typical substrate mask size of 6 inches. Of course, the spacing can be adapted as will be suitable for other realizations of the invention.

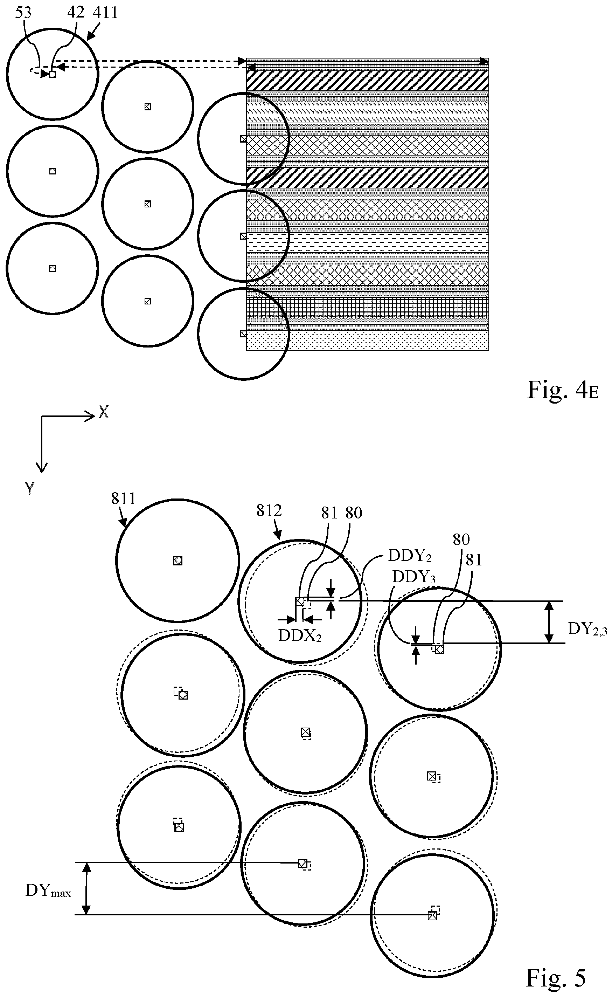

It is to be noted that the positions discussed in Figs. 2 and 3 represent an idealized case where the columns, i.e. the respective base points thereof, are precisely positioned at the ideal grid positions. In a more realistic scenario, the columns may have individual deviations from their grid positions due to limitations of the construction accuracy. One example of such a more realistic case is shown in Fig. 5, which depicts an array of columns having (exaggerated) deviations from the ideal grid positions; again the columns are indicated by black circles and their respective beam fields as squares 81 in the center. For instance, the position of the middle uppermost column 812 has offsets DDX₂ and DDY₂ along the X and Y directions from its ideal position on a staggered grid depicted by dashed circles and squares 80.

### Multi-Column Write Strategy

Exemplary write strategies for the multi-column architecture for exposing the substrate are illustrated in Figs. 4A to 4E, which relate to the basic write strategy for ideal positions, as well as Figs. 9 and 10, which illustrate to the writing strategy including realistic positions that slightly deviate from ideal positions.

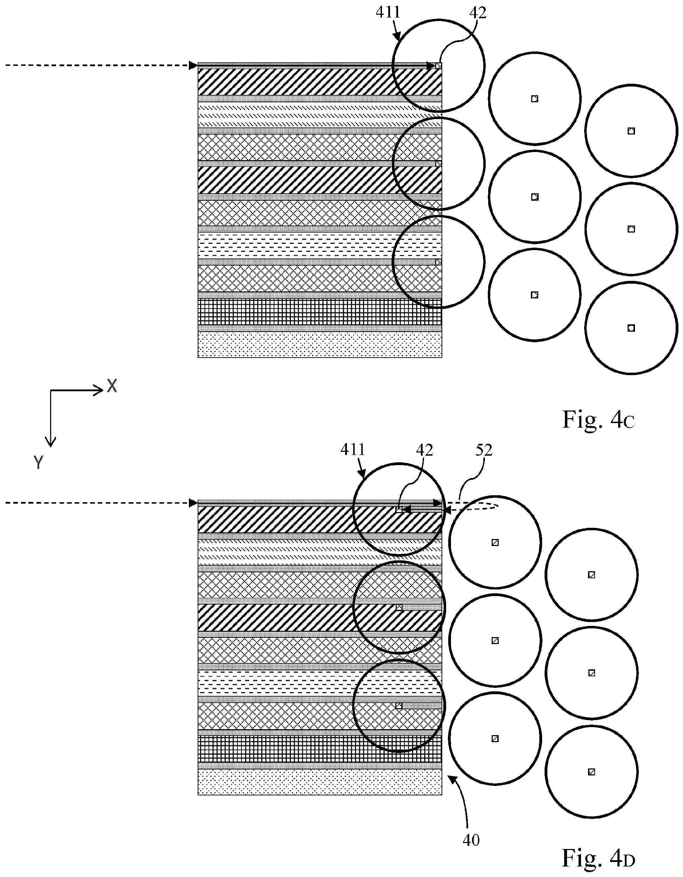

Figs. 4A to 4E show a sequence of several stages of an exemplary exposure process employing the staggered grid layout of Fig. 3. It is reminded that it is the relative movement between the target and the array of particle-optical columns which is significant, even though the depiction in Figs. 4A-4E is treating the exposure region as fixed (this reflects a viewpoint which is centered on the pattern to be written on the target) and shows the relative variable positions of the particle-optical columns as moving. Fig. 4A depicts the array of columns of the staggered grid layout at the start of an exposure process; the array is positioned at an initial position such that all column beam fields 42 are outside of the exposure area 40 (exposure region), which is partitioned into exposure fields as can bee seen in Fig. 4A, and the initial positions of the beam fields 42 are aligned with the respective starting edges of the exposure areas along the X direction (as indicated by dashed-dotted lines in Fig.4A); additionally, preferably, the beam fields of the columns 413, 423, 433 of a first column line (in Fig. 4A the right-most column line) are just at one edge of the exposure area 40 and all other column beam fields 42 are outside of the exposure area 40. Starting from the configuration shown in Fig. 4A, one stripe is exposed along the X direction. Fig. 4B illustrates one intermediate position corresponding to about 60% through the entire length along the X direction of the writing process. The path of the beam field 42 of the column 411 at the uppermost left-hand position (as representative for the entire columns array) is indicated by a dashed arrow for movement along stripes within each exposure field, and a solid-line arrow indicates movement along the stripes covering areas where a pattern is written. The other columns are locked in the arrangement since the entire column array moves as one block, and thus they will move likewise as column 42, but at respective horizontal offsets with respect to column 42. During the movement along the stripes the beam field of each column is manipulated by its respective PD system in accordance with the desired pattern to be written on the target, which allows to transfer the target pattern to the exposure field on the substrate. In Fig. 4B and subsequent Figs. 4C-E the already-patterned areas in the exposure area are indicated by gray stripes 51 as the columns are moved along some distance into the exposure area. Fig. 4C illustrates the relative position of the column array where the first stripes in each of the exposure fields have been finished. Next, the column arrangement does a half turn, indicated by the arrow 52, and starts writing a second set of stripes, with the writing being performed in the opposite direction; i.e., in the example shown, the -X direction, i.e. inverse to the X direction. For instance, Fig. 4D shows the process of exposing the second stripes of the exposure fields along the -X direction (shown is a position corresponding to about 10% of the entire length of writing). Fig. 4E shows the arrangement after having finished the second stripes; furthermore, yet another half turnof the path of column array is indicated at arrow 53, upon which the exposure of the third stripes can start. The above-described procedure is repeated until the plurality of stripes thus exposed covers the entire exposure area. It is important to note that during the half-turn path between subsequent stripes, as indicated in Figs. 4D and 4E by the dashed U-shaped arrows 52, 53, all beam fields are moved completely outside of the exposure area 40.

In other words, the paths include U-shaped turns indicated by arrows 52, 53 which ensure that the target is moved to a position which ensures that all beam fields 42, which are at the locations of the base-points of the particle-optical columns 413-433, are (temporarily, namely, between writing one stripe and writing the subsequent stripe respectively) moved out of the exposure area 40. This serves to ensure that at the beginning and the end of each stripe that is written, the array of beam fields is properly set up; furthermore, this ensures that each beam field has the same amount of time duration above the exposure area 40, so as to minimize non-equal effects of heating, charging and secondary effects on the target. In other words, this movement of the target serves to have the exposure area 40 bypass all base points 42 of the particle-optical columns 413-433.

In a favorable embodiment of the invention, also depicted in Fig. 3, successive column lines of the staggered grid in the direction transverse to the Y direction have a Y offset of DY/m, with m being the number of column lines in the grid (m=3 and offset DY/3 in Fig. 3). This allows for a complete coverage of the exposure area with exposure fields assigned to only a single column each. Hence, the exposure area can be exposed faster than with an arrangement as in Fig. 2, without a Y offset between the column lines, where multiple columns expose the same exposure field. The former arrangement allows to increase the throughput of the exposure apparatus. On the other hand, the latter, redundant, arrangement allows for increased precision and defect tolerance: 1) Non-systematic error contributions from all columns exposing the same exposure field are averaged which results in a lower final maximum error. 2) A specifically selected column may be disabled, for instance in case of a defect, and the other columns exposing the same exposure field can compensate without loss of throughput.

It should be noted, however, that in many embodiments of the invention the pitches DY and DY/m may be incommensurate with the width of the beam array field width, and thus will not be an integer multiple of the beam array field width. Therefore, the target pattern area of at least one of the stripes in the exposure sequence will have a smaller width than the beam array field width.

In the case of a rectangular column grid layout comprising several column lines (e.g. three column lines, i.e. three particle-optical columns in a row, m=3), m particle-optical columns are assigned to each exposure field and they all will expose the same exposure area by writing the respective stripes thereof. The exposure sequence is analogous to the one described above and in Fig. 4A to 4E, but in this case with zero offsets along the Y direction. In addition, each column is allowed to reduce the total dose it deposits on the substrate for patterning by a factor of m to a fraction 1/m. Then the originally targeted dose for the pattern will be delivered to the substrate. Of course, it is possible to implement writing procedures according to a multiple passes exposure strategy, as described in US 9,053,906 of the applicant, for any type of array grid layout, including those of Figs. 2 and 3.

In realistic scenarios the accuracy of mutual positioning of the column will be limited. For instance, it may only be possible to arrange the columns accurately to a few tens of micrometers and so the pitches DX and DY, as well as the pertinent offsets, will not be precisely equal between adjacent columns. For the purpose of this invention, pitches and offsets are considered as equal if all deviations from nominal column positions are larger than the deflection range that the beam deflection means of the columns are able to accomplish; this deflection range is typically a few hundreds of nanometers. The beam deflection means is generally employed to keep the beam array locked on to its target position during the exposure process while the substrate is continuously moved along the write direction. In addition, it can also be used to compensate for a variety of placement errors, including those described in other patents by the applicant such as US 10,325,756, but excluding errors in the column arrangement in general.

Fig. 5 depicts the staggered column arrangement of Fig. 3 where also exemplary deviations from the nominal positions are indicated. In particular, dashed lines indicate the nominal positions of circumferences of the columns and beam fields 80, with respect to a regular staggered grid with uniform pitches DX and DY and Y offsets, whereas the corresponding actual positions are depicted using solid lines (i.e., solid circles and solid squares 81). The "first" column 811 is used as a reference, thus its actual position coincides with its nominal position. The deviations of the actual positions from nominal positions are labeled in Fig. 5 only for the example of the middle uppermost column 812, i.e. deviation distances DDX₂ and DDY₂ for column 812. In order to simplify notation in the following, the columns are numbered by a single index i (which in the 3×3 arrangement of Figs. 3 and 5 takes values i = 1 ... 9); and we define the deviation DDXᵢ and DDYᵢ from the nominal position for the i-th column. The actual Y offset between the i-th and k-th columns is denoted as DY_{i,k}, for instance DY_{2,3} between the second and third columns.

For this slightly distorted column arrangement it will not be possible to cover the entire exposure area with writing sweeps without adapting the area and/or number of stripes exposed by the columns. For instance, as depicted in Fig. 5, DDY₂ is positive and DDY₃ is negative, so DY_{2,3} is larger than DY, and this may require at least one additional stripe for writing the area between the two columns of i=2 and i=3. During exposure of the additional stripe column of i=1 will pass over an area portion that has already been exposed by column of i=2, and in order to avoid a duplicated exposure it will be advantageous to have its beams switched off in such area portion.

### Overlap Margins

Methods for the writing of parallel stripes have been described in US 8,378,320 of the applicant. In order to further improve the transition of features across the boundary between adjacent exposure stripes, even when butting errors should occur, US 8,378,320 proposes an exposure method which is based on overlap margins but uses an improved strategy in the context of multi-beam exposure. This mechanism of overlapping margins described above is adapted as described in the following for writing in a multi-column multi-beam exposure.

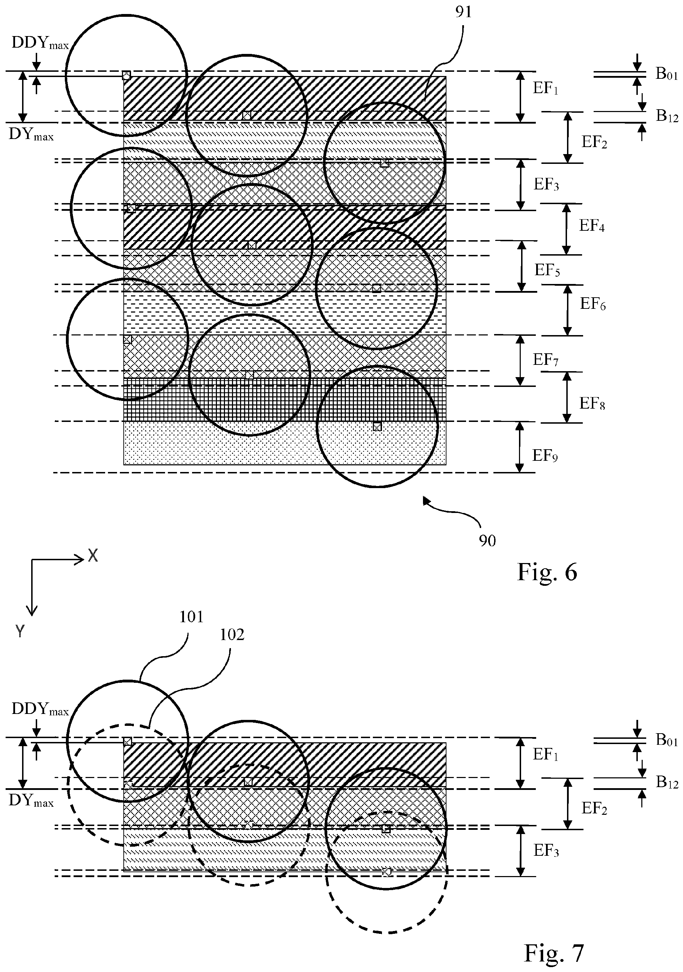

Referring to Fig. 6, overlap margins may be provided at the edges of exposure fields (instead of stripes), typically two overlap margins located at either edge of an exposure field. For instance, the exposure field 91 associated with column of i=1 is extended by adding overlap margins B₀₁ and B₁₂ so that it effectively has an extent indicated as EF₁. Margin B₁₂ also indicates a corresponding overlap margin of the adjacent exposure field EF₂. By superimposing respectively two overlap margins of adjacent exposure fields EF₁, ..., EF₉ is possible to reconstruct a continuous image pattern on the target. Within the range of an overlap on the target as defined by the overlap margins of two adjacent exposure fields EFₖ, EFₖ₊₁, the exposure is effected partially in the course of exposure of the overlap margin of the first EFₖ of the two exposure fields, and partially in the course of exposure of the second one EFₖ₊₁; the two column exposures will combine so as to produce a full exposure equivalent to the main part of the exposure fields (i.e., the region of the exposure fields without overlapping).

The previous discussion includes that exposure fields are covered stripe-wise during the exposure process and that any fraction of a stripe or even multiple stripes may fall into the overlap margin of an exposure field

As described in US 8,378,320 (and in contrast to US 7,129,024), the method according to the present invention divides the pixels to be exposed on the target, by assigning each pixel in an overlap region to one of the (two) overlap margins that are superimposed at the respective location. The respective dose values of the pixels thus exposed are not changed, regardless of which exposure field generates the pixel.

Further details about overlap margins can be found in US 8,378,320, whose disclosure with regard to overlap margins is included herein by reference.

Referring to Fig. 7 (which only shows the top three columns of the arrangement of Fig. 6), the exposure fields and individual overlap margins on either side may be defined as follows: First, determine the largest offset value DYₘₐₓ of the offsets DYᵢ, i.e. DYₘₐₓ = maxᵢ DYᵢ, and use this value DYₘₐₓ as the extended exposure field size for each column. Then, for each exposure area define an extended exposure area, whose upper left corner is located at the upper left corner of the exposure area enlarged by the largest column deviation DDYₘₐₓ = maxᵢ DDYᵢ from their nominal grid positions. Then, align the upper edge of each extended exposure field with the starting position 101 of its column and the bottom edge at a distance of DYₘₐₓ with its final position 102.

The overlap margin between adjacent stripes allows to reduce butting errors between adjacent stripes written by the respective columns, or exposure fields: Systematic errors arising along the boundary (or transition) between two columns or stripes will be reduced by "mixing" the pattern portions written by the various columns or stripes, so as to smoothen the transition from one exposure field to the next, as discussed in more detail in the above-mentioned US 8,378,320. Furthermore, additional stripes may be inserted at the very top and bottom of a contiguous patch of stripes covering the pattern so that the leaked dose is homogeneous throughout the pattern.

The invention has been described in the context of certain embodiments for illustrative purposes. It will be evident that the invention can be readily applied to other implementations as well by the skilled person, without departing from the scope of the invention as declared in the appended claims.

## Claims

1. A charged-particle multi-beam processing apparatus (1) for exposure of a target (107) to write a desired pattern thereon using a plurality of beams of electrically charged particles, said apparatus comprising
a target stage (105) configured to receive the target, the target having a predefined total area including an exposure region where the desired pattern is to be written, and
a plurality of particle-optical columns (109) configured for directing respective charged-particle beams towards the target (107) and thereby writing the desired pattern on the target,
said target stage (105) being configured to position the target at a specific position within a predefined target plane, and a main direction defined therein, and relative to the plurality of particle-optical columns,
said plurality of particle-optical columns (109) being arranged along respective longitudinal axes traversing the target plane at respective base points,
wherein each particle-optical column (109) is configured to project its respective charged-particle beam onto the target at a respective region around the respective base point to generate, in said region, a pattern portion image corresponding to a portion of a pattern to be exposed on the target in accordance with the location of the respective base point of the particle-optical column within the target plane, said pattern portion image having a lateral width as measured across said main direction, referred to as "stripe width",
wherein the charged-particle multi-beam processing apparatus is configured to generate a relative movement between said target and the plurality of particle-optical columns along said main direction while said plurality of particle-optical columns generate a plurality of pattern portion images on the target, thus moving the pattern portion images across the target along respective paths along said main direction and writing exposure stripes on the target running substantially parallel to each other along said main direction,
wherein said plurality of particle-optical columns (109), as regards their respective base points, are arranged according to a pre-defined array within which the particle-optical columns form at least two lines extending perpendicular to said main direction, each of said at least two lines comprising at least one particle-optical column, said lines being offset relative to each other according to a longitudinal spacing as measured along said main direction, and within each of said lines where the line comprises more than one particle-optical column, the particle-optical columns are distanced according to a uniform row offset which is at least twice the stripe width,
wherein the apparatus is configured to repeat the process of writing exposure stripes at least once, preferably multiple times, each time at a lateral offset with respect to the respectively preceding process of writing exposure stripes, where the lateral offset, as measured perpendicular to the main direction, is not larger than the stripe width, and is configured to reposition, before each repeat using the stage, the target in accordance with a repositioning path of the target, where the repositioning path comprises a path portion which bypasses the base points of the particle-optical columns by relatively moving the plurality of particle-optical columns (109) to locations where all base points of the particle-optical columns are completely outside of the exposure region or the total area of the target.

2. The apparatus of claim 1, wherein said plurality of particle-optical columns are arranged in a rectangular array having n rows of particle-optical columns extending perpendicular to the lines, each row comprising m particle-optical columns, with n ≥ 1 and m ≥ 2.

3. The apparatus of claim 1, wherein said plurality of particle-optical columns are arranged in a staggered array having n rows of particle-optical columns, with n ≥ 1, each row comprising m ≥ 2 columns, wherein between adjacent lines the particle-optical columns are offset by a transversal offset which is smaller than the longitudinal spacing, and which preferably is half of the row offset or 1/m of the row offset.

4. The apparatus of any one of the preceding claims, wherein each particle-optical column (109) comprises:
an illumination system (111),
a beam shaping device (112), and
a projection optics system (116),
the illumination system (111) being configured to produce a respective beam and form it into a substantially telecentric beam illuminating the shaping means, the beam shaping device (112) being configured to form the shape of the illuminating beam into a pattern portion composed of a multitude of sub-beams, said pattern portion corresponding to a portion of a pattern to be exposed on the target in accordance with the location of the respective base point of the particle-optical column within the target plane, and the projection optics system (116) being configured to project an image of the beam shape defined in the shaping means onto the target (107) thus forming said pattern portion image.

5. Method for writing a desired pattern on a target using a charged-particle multi-beam processing apparatus comprising
a target stage (105) configured to receive and position the target within a predefined target plane, said target plane having a main direction defined therein, for a target having a predefined total area including an exposure region where the desired pattern is to be written, and
a plurality of particle-optical columns (109) configured for directing respective charged-particle beams towards the target (107) and thereby writing the desired pattern on the target,
wherein said plurality of particle-optical columns (109) are arranged along respective longitudinal axes traversing the target plane at respective base points, and the particle-optical columns, as regards their respective base points, being arranged according to a pre-defined array, within which the particle-optical columns form at least two lines extending perpendicular to said main direction, each of said at least two lines comprising at least one particle-optical column, said lines being offset to each other according to a longitudinal spacing as measured along said main direction, and within each of said lines, in the case where it respectively comprise more than one particle-optical column, the particle-optical columns are mutually distanced according to a uniform row offset,
the method comprising the steps of:
positioning, using the target stage (105), the target at a specific position within the target plane and relative to the plurality of particle-optical columns,
projecting, in each particle-optical column (109), a respective charged-particle beam onto the target at a respective region around the respective base point to generate, in said region, a pattern portion image corresponding to a portion of a pattern to be exposed on the target in accordance with the location of the respective base point of the particle-optical column within the target plane, said pattern portion image having a lateral width as measured across said main direction, referred to as "stripe width", wherein the row offset, in the case of lines comprising more than one particle-optical column, is at least twice the stripe width,
generating a relative movement between said target and the plurality of particle-optical columns along said main direction while said plurality of particle-optical columns generate a plurality of pattern portion images on the target, and thus moving the pattern portion images across the target along respective paths along said main direction and writing exposure stripes on the target running substantially parallel to each other along said main direction, each exposure stripe being exposed by either one single particle-optical column or one group of two or more particle-optical columns arranged along said main direction,
wherein said steps are repeated, each time at a lateral offset as measured perpendicular to the main direction, with respect to the respectively preceding completion of said steps, said lateral offset being not larger than the stripe width, for exposing an exposure region on the target,
wherein between each repeat the stage repositions the target using a repositioning path of the target, where the repositioning path comprises a path portion which bypasses the base points of the particle-optical columns by relatively moving the plurality of particle-optical columns (109) to locations where all base points of the particle-optical columns are completely outside of the exposure region or the total area of the target.

6. The method of claim 5, wherein the exposure stripes are formed within a pre-defined exposure region on the target traversing the exposure region along the main direction, wherein the exposure stripes formed during each single traversal of the exposure region cover only a fraction of the exposure region, and the forming of exposure stripes is repeated with respective offsets perpendicular to the main direction so as to cover the exposure region.

7. The method of claim 5 or 6, wherein the stripes written in a complete number of repeats are written in a consecutive order in at least two passes, wherein each stripe belongs to exactly one of said passes,
wherein for each pass, the widths of the stripes of one pass combine into a cover of the width of the exposure region as measured across said main direction,
wherein each pass is associated with one of a number of partial grids of pattern pixels which are exposable during the respective pass, the partial grids being mutually different and,
when taken together, combining to the complete plurality of pattern pixels which compose the pattern to be exposed in the exposure region.

8. The method of claim 7, wherein each particle-optical column contributes to writing portions of the desired pattern in each of the at least two passes, and preferably contributes to writing mutually corresponding portions between the passes.

9. The method of claim 7, wherein each pass is associated with one of a plurality of groups of particle-optical columns, the groups of particle-optical columns being mutually disjoint, and the stripes of each pass are exposed only by particle-optical columns of the respectively associated group of particle-optical columns.

10. The method of any one of claims 7 to 9, wherein during writing of each single stripe, the particle-optical columns at corresponding positions within each line contribute to the same stripe exposing the same partial grid, and the writing of the stripe is repeated to expose each of the number of partial grids.

11. The method of any one of the claims 5 to 10, wherein with respect to grid rows of particle-optical columns formed by particle-optical columns located at corresponding positions within each line, during an exposure process for writing the desired pattern, for each row a selected particle-optical column in each row is switched off during the exposure process, wherein the selected particle-optical columns of the rows are mutually corresponding with respect to the desired pattern being written.

12. The method of claim 11, wherein a selection of particle-optical columns for being switched off takes place upon detection of a particle-optical column being defective or otherwise unsuitable for a writing process, where said defective or otherwise unsuitable column is selected as one of the particle-optical columns to be switched off.

13. The method of any one of claims 5 to 12, wherein at least two stripes written by different columns are partly overlapping, wherein in the range of overlap of stripes with respect to pattern pixels forming the desired pattern:
nominal positions of pattern pixels of one of the two stripes are overlapping with nominal positions of corresponding pattern pixels of the other of the two stripes, and
pattern pixels are exposed in the at least two overlapping stripes in a complementary manner with regard to the desired pattern.
